# EUROPEAN PATENT APPLICATION

(11) **EP 4 443 492 A1**
(43) Date of publication of application: **09.10.2024**
(21) Application number: 22901371.9
(22) Date of filing: 30.11.2022
(51) Int. Cl.: H01L 23/36, H01L 23/12

(54) **TEMPORARY FASTENING MATERIAL, AND MANUFACTURING METHOD FOR JOINED BODY**

(30) Priority: 30.11.2021 JP 2021194457; 29.11.2022 JP 2022190222
(71) Applicant: Mitsubishi Materials Corporation, Tokyo 100-8117 (JP)
(72) Inventor: SAKURAI, Akira, Saitama-shi, Saitama 330-8508 (JP); TERASAKI, Nobuyuki, Saitama-shi, Saitama 330-8508 (JP); GOMYO, Mika, Saitama-shi, Saitama 330-8508 (JP); NISHIKAWA, Kimihito, Sunto-gun, Shizuoka 410-1312 (JP)
(74) Representative: Hoffmann Eitle
(86) International application number: PCT/JP2022/044210
(87) International publication number: WO 2023/100939

(57) **Abstract**

A temporarily fixing material according to the present embodiment includes an acrylic resin, a plasticizer composed of adipate, and a solvent, the amount of the acrylic resin is 5 mass% or more, and a ratio A/B of a weight A of the plasticizer to a weight B of the acrylic resin is in a range of 0.07 ≤ A/B ≤ 1.50.

## Description

### TECHNICAL FIELD

The present invention relates to a temporarily fixing material used in a case of temporarily fixing a first member and a second member, and a method for manufacturing a bonded body using this temporarily fixing material.

Priority is claimed on Japanese Patent Application No. 2021-194457, filed November 30, 2021, and Japanese Patent Application No. 2022-190222, filed November 29, 2022, the contents of which are incorporated herein by reference.

### BACKGROUND ART

A power module, an LED module, and a thermoelectric module have a structure in which a power semiconductor element, an LED element, and a thermoelectric element are bonded to an insulating circuit substrate in which a circuit layer made of a conductive material is formed on one surface of an insulating layer.

In addition, the insulating circuit substrate described above may also be provided with a structure in which a circuit layer obtained by bonding a metal piece having excellent conductivity to one surface of an insulating layer is provided and a metal layer is formed by bonding a metal piece having excellent heat radiation to the other surface thereof.

In addition, in order to efficiently dissipate heat generated in elements and the like mounted on the circuit layer, an insulating circuit substrate attached with a heat sink, in which a heat sink is bonded to the other surface side of the insulating layer, is also provided.

For example, Patent Document 1 discloses a power module including an insulating circuit substrate, in which a circuit layer is formed by bonding an aluminum piece to one surface of a ceramic substrate and a metal layer is formed by bonding an aluminum piece to the other surface thereof, and a semiconductor element bonded onto the circuit layer via a solder material.

In addition, Patent Document 2 proposes an insulating circuit substrate in which a circuit layer in which an aluminum layer and a copper layer are laminated is formed by bonding an aluminum piece to one surface of a ceramic substrate and bonding a copper piece to this aluminum piece by diffusion in solids.

Further, Patent Document 3 discloses an LED module having a structure in which a conductive circuit layer is formed on one surface of a base material formed of ceramics, a heat radiator is bonded to the other surface of an insulating substrate, and a light emitting element is mounted on the circuit layer.

Here, in a case of bonding a ceramic substrate to a metal piece, an aluminum piece to a copper piece, or an insulating circuit substrate to a heat sink, for example, as disclosed in Patent Documents 4 to 6, members are bonded to each other by positioning the members using a temporarily fixing material including an organic material such as polyethylene glycol (PEG) between the members to be bonded, and pressing and heating the members in a laminating direction in a temporarily fixed state.

### [Citation List]

### [Patent Documents]

[Patent Document 1]
   Japanese Patent No. 3171234
[Patent Document 2]
   Japanese Patent No. 5403129
[Patent Document 3]
   Japanese Unexamined Patent Application, First Publication No. 2015-070199
[Patent Document 4]
   Japanese Unexamined Patent Application, First Publication No. 2014-175425
[Patent Document 5]
   Japanese Unexamined Patent Application, First Publication No. 2014-209591
[Patent Document 6]
   Japanese Unexamined Patent Application, First Publication No. 2016-105452

### SUMMARY OF INVENTION

### Technical Problem

Meanwhile, in recent years, a size of members to be bonded has been reduced, and a bonding area has been reduced. Accordingly, improvement of fixing strength by a temporarily fixing material is required more than ever before. In addition, there is a demand that the members temporarily fixed using the temporarily fixing material are reliably bonded to each other and an appearance after the bonding is favorable.

The present invention has been made in view of the aforementioned circumstances, and an object thereof is to provide a temporarily fixing material capable of reliably temporarily fixing members to each other, and a method for manufacturing a bonded body capable of bonding members with excellent positional accuracy by positioning the members using the temporarily fixing material.

### Solution to Problem

In order to achieve the aforementioned objects, a temporarily fixing material according to Aspect 1 of the present invention includes an acrylic resin, a plasticizer consisting of adipate, and a solvent, the amount of the acrylic resin is set to 5 mass% or more, and a ratio A/B of a weight A of the plasticizer to a weight B of the acrylic resin is set to be in a range of 0.07 ≤ A/B ≤ 1.50.

According to the temporarily fixing material according to Aspect 1 of the present invention, the acrylic resin and the plasticizer consisting of adipate are included, the amount of the acrylic resin is 5 mass% or more, and the ratio A/B of the weight A of the plasticizer to the weight B of the acrylic resin is in the range of 0.07 ≤ A/B ≤ 1.50. Therefore, as the temporarily fixing material is disposed and pressed between the members, it is possible to suppress deviation of the members by an adhesive force of the temporarily fixing material.

A method for manufacturing a bonded body according to Aspect 2 of the present invention in which a first member and a second member are bonded, the method includes: a laminating step of laminating the first member and the second member, and a bonding step of bonding the laminated first member and second member, and the laminating step includes a temporarily fixing material disposing step of disposing the temporarily fixing material according to Aspect 1 of the present invention on one or both of bonding surfaces of the first member and the second member, and a temporarily fixing step of laminating the first member and the second member through the temporarily fixing material and temporarily fixing the laminated first member and second member.

According to the method for manufacturing the bonded body according to Aspect 2 of the present invention, the temporarily fixing material according to Aspect 1 of the present invention is disposed between the first member and the second member, the first member and the second member are laminated, the laminated first member and second member are temporarily fixed, and the temporarily fixed first member and second member are bonded to each other. Therefore, in the bonding step, it is possible to reliably suppress the deviation of the first member and the second member, and it is possible to bond the first member and the second member with excellent positional accuracy.

According to Aspect 3 of the present invention, the method for manufacturing the bonded body according to Aspect 2 includes a temporarily fixing material drying step of drying the temporarily fixing material disposed in the temporarily fixing material disposing step, before the temporarily fixing step.

According to the method for manufacturing the bonded body according to Aspect 3 of the present invention, the method for manufacturing the bonded body further includes the temporarily fixing material drying step of drying the temporarily fixing material disposed in the temporarily fixing material disposing step, before the temporarily fixing step. Therefore, it is possible to improve an adhesive force of the temporarily fixing material by drying, and it is possible to reliably temporarily fix together the first member and the second member.

According to Aspect 4 of the present invention, in the method for manufacturing the bonded body according to Aspect 2 or 3 of the present invention, the first member is an aluminum member formed of aluminum or an aluminum alloy, and the second member is a copper member formed of copper or a copper alloy.

According to the method for manufacturing the bonded body according to Aspect 4 of the present invention, the first member is the aluminum member and the second member is the copper member. Therefore, as these aluminum member and copper member are temporarily fixed with the temporarily fixing material and the aluminum member and the copper member are bonded by diffusion in solids, it is possible to reliably bond the aluminum member and the copper member with excellent positional accuracy.

According to Aspect 5 of the present invention, in the method for manufacturing the bonded body according to Aspect 4 of the present invention, the first member which is the aluminum member is a heat sink.

According to the method for manufacturing the bonded body according to Aspect 5 of the present invention, it is possible to reliably bond the heat sink formed of aluminum or an aluminum alloy and the copper member formed of copper or a copper alloy with excellent positional accuracy.

In addition, according to Aspect 6 of the present invention, in the method for manufacturing the bonded body according to Aspect 4 of the present invention, the second member which is the copper member is a heat sink.

According to the method for manufacturing the bonded body according to Aspect 6 of the present invention, it is possible to reliably bond the heat sink formed of copper or a copper alloy and the aluminum member formed of aluminum or an aluminum alloy with excellent positional accuracy.

In addition, according to Aspect 7 of the present invention, in the method for manufacturing the bonded body according to Aspect 2 or 3 of the present invention, the first member is a metal part, and the second member is a brazing material.

According to the method for manufacturing the bonded body of Aspect 7 of the present invention, the first member is the metal part, the second member is the brazing material, and the metal part and the brazing material are temporarily fixed with the temporarily fixing material described above. Therefore, it is possible to position and temporarily fix together the metal part and the brazing material with excellent accuracy.

According to Aspect 8 of the present invention, in the method for manufacturing the bonded body according to Aspect 2 or 3 of the present invention, the first member is an aluminum member formed of aluminum or an aluminum alloy, and the second member is an aluminum member formed of aluminum or an aluminum alloy.

According to the method for manufacturing the bonded body according to Aspect 8 of the present invention, the first member is the aluminum member and the second member is the aluminum member. Therefore, it is possible to temporarily fix together the aluminum member and the aluminum member with the temporarily fixing material described above, and it is possible to reliably bond the aluminum member and the aluminum member with excellent positional accuracy.

In addition, according to Aspect 9 of the present invention, in the method for manufacturing the bonded body according to Aspect 2 or 3 of the present invention, the first member is a copper member formed of copper or a copper alloy, and the second member is a copper member formed of copper or a copper alloy.

According to the method for manufacturing the bonded body according to Aspect 9 of the present invention, the first member is the copper member and the second member is the copper member. Therefore, it is possible to temporarily fix together the copper member and the copper member with the temporarily fixing material described above, and it is possible to reliably bond the copper member and the copper member with excellent positional accuracy.

In addition, according to Aspect 10 of the present invention, in the method for manufacturing the bonded body according to Aspect 2 or 3 of the present invention, the first member is a ceramic member, and the second member is a brazing material.

According to the method for manufacturing the bonded body of Aspect 10 of the present invention, the first member is the ceramic member, the second member is the brazing material, and the metal part and the brazing material are temporarily fixed with the temporarily fixing material described above. Therefore, it is possible to position and temporarily fix together the ceramic member and the brazing material with excellent accuracy.

### ADVANTAGEOUS EFFECTS OF INVENTION

According to the present invention, it is possible to provide a temporarily fixing material capable of reliably temporarily fixing members to each other, and a method for manufacturing a bonded body capable of bonding members with excellent positional accuracy by positioning the members using the temporarily fixing material.

### BRIEF DESCRIPTION OF DRAWINGS

FIG. 1 is a cross-sectional explanatory view of an insulating circuit substrate and a power module manufactured by a method for manufacturing a bonded body according to a first embodiment of the present invention.
FIG. 2 is a flowchart showing a method for manufacturing the insulating circuit substrate and the power module shown in FIG. 1.
FIG. 3 is an explanatory view showing the method for manufacturing the insulating circuit substrate shown in FIG. 1.
FIG. 4 is an explanatory view showing the method for manufacturing the insulating circuit substrate shown in FIG. 1.
FIG. 5 is a cross-sectional explanatory view of an insulating circuit substrate and a power module manufactured by a method for manufacturing a bonded body according to a second embodiment of the present invention.
FIG. 6 is a flowchart showing a method for manufacturing the insulating circuit substrate and the power module shown in FIG. 5.
FIG. 7 is an explanatory view showing the method for manufacturing the insulating circuit substrate shown in FIG. 5.
FIG. 8 is an explanatory view showing the method for manufacturing the insulating circuit substrate shown in FIG. 5.
FIG. 9 is an explanatory view showing the method for manufacturing the insulating circuit substrate shown in FIG. 5.

### DESCRIPTION OF EMBODIMENTS

Hereinafter, an embodiment of the present invention will be described with reference to the accompanying drawings.

### <First Embodiment>

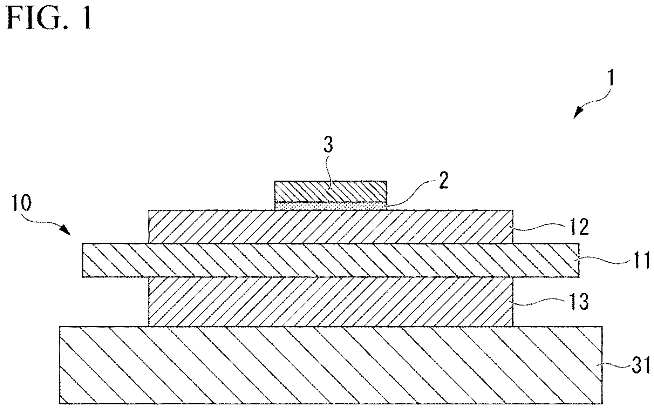

A first embodiment of the present invention will be described with reference to FIGS. 1 to 4. FIG. 1 shows an insulating circuit substrate 10 and a power module 1 manufactured by a method for manufacturing a bonded body using a temporarily fixing material of the present embodiment.

The power module 1 includes the insulating circuit substrate 10 on which a circuit layer 12 and a metal layer 13 are disposed, a semiconductor element 3 bonded to one surface (upper surface in FIG. 1) of the circuit layer 12 through a bonding layer 2, and a heat sink 31 disposed on the other side (lower side in FIG. 1) of the metal layer 13.

The semiconductor element 3 is formed of a semiconductor material such as Si. The semiconductor element 3 and the circuit layer 12 are bonded through the bonding layer 2.

The bonding layer 2 is formed of, for example, an Sn-Ag-based solder material, an Sn-In-based solder material, or an Sn-Ag-Cu-based solder material.

As shown in FIG. 1, the insulating circuit substrate 10 includes a ceramic substrate 11 which is an insulating layer, a circuit layer 12 disposed on one surface (an upper surface in FIG. 1) of the ceramic substrate 11, and a metal layer 13 which is formed on the other surface (a lower surface in FIG. 1) of the ceramic substrate 11.

The ceramic substrate 11 prevents electrical connection between the circuit layer 12 and the metal layer 13 and is formed of a material having high insulating properties, for example, aluminum nitride (AlN) or silicon nitride (Si₃N₄). In addition, the thickness of the ceramic substrate 11 is set to be in a range of 0.2 mm or more and 1.5 mm or less, and, in the present embodiment, the thickness thereof is set to 0.635 mm using aluminum nitride (AlN) as the ceramic substrate 11. In a case where silicon nitride (Si₃N₄) is used as the ceramic substrate 11, the thickness is preferably set to 0.32 mm.

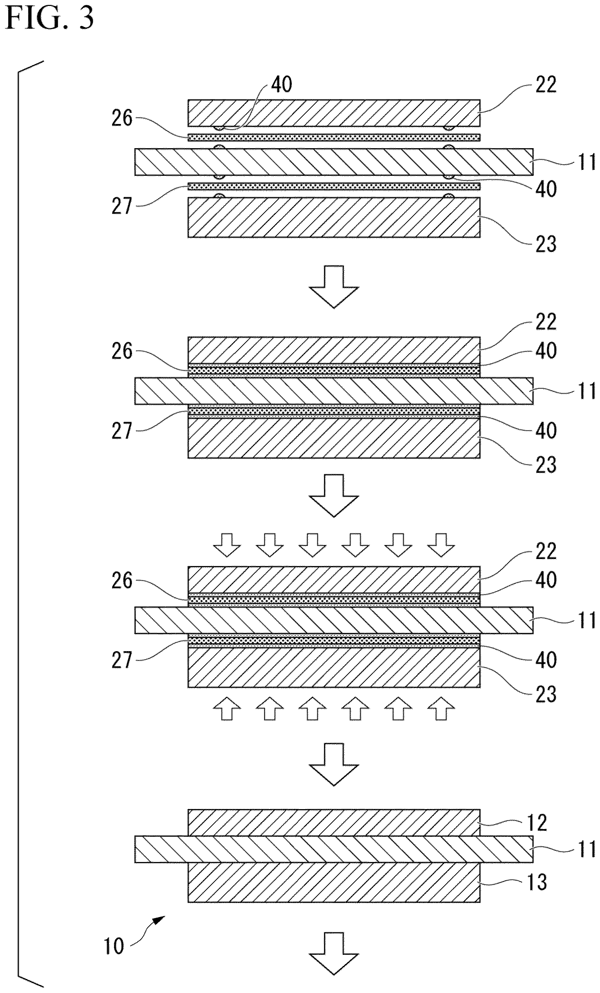

As shown in FIG. 3, the circuit layer 12 is formed by bonding a metal piece 22 formed of copper, a copper alloy, aluminum, or an aluminum alloy to one surface of the ceramic substrate 11. In other words, the circuit layer 12 is configured with the metal piece 22 bonded to one surface of the ceramic substrate 11, and the metal piece 22 is formed of copper, a copper alloy, aluminum, or an aluminum alloy.

As copper or a copper alloy, oxygen-free copper, tough pitch copper, or the like can be used. In addition, as aluminum or an aluminum alloy, aluminum having a purity of 99.99 mass% or more (so-called 4N aluminum), a rolled plate of A3003 alloy, A6063 alloy, and the like can be used. In the present embodiment, as the metal piece 22 configuring the circuit layer 12, a punched rolled plate of oxygen-free copper can be used.

In the circuit layer 12, a circuit pattern is formed by bonding the metal pieces 22 described above in a pattern, and one surface thereof (upper surface in FIG. 1) serves as a mounting surface on which the semiconductor element 3 is mounted. Here, the thickness of the circuit layer 12 is set to be in a range of 0.1 mm or more and 2.0 mm or less, and is set to 0.8 mm in the present embodiment.

As shown in FIG. 3, the metal layer 13 is formed by bonding a metal piece 23 formed of copper, a copper alloy, aluminum, or an aluminum alloy to the other surface of the ceramic substrate 11. In other words, the metal layer 13 is configured with the metal piece 23 bonded to the other surface of the ceramic substrate 11, and the metal piece 23 is formed of copper, a copper alloy, aluminum, or an aluminum alloy.

As the metal piece 23, a metal piece formed of oxygen-free copper or tough pitch copper can be used. In addition, as aluminum or an aluminum alloy, aluminum having a purity of 99.99 mass% or more (so-called 4N aluminum), a rolled plate of A3003 alloy, A6063 alloy, and the like can be used. In the present embodiment, a rolled plate of oxygen-free copper is used as the metal piece 23 configuring the metal layer 13. Here, the thickness of the metal layer 13 is set to be in a range of 0.1 mm or more and 2.0 mm or less, and is set to 0.8 mm in the present embodiment.

The heat sink 31 is for dissipating heat on the insulating circuit substrate 10 side. The heat sink 31 is formed of a material having excellent thermal conductivity, for example, aluminum or an aluminum alloy, and, in the present embodiment, is formed of A6063 alloy. The thickness of the heat sink 31 is set to be in a range of 3 mm or more and 10 mm or less.

In the present embodiment, the metal layer 13 of the insulating circuit substrate 10 and the heat sink 31 are bonded by bonding of diffusion in solids.

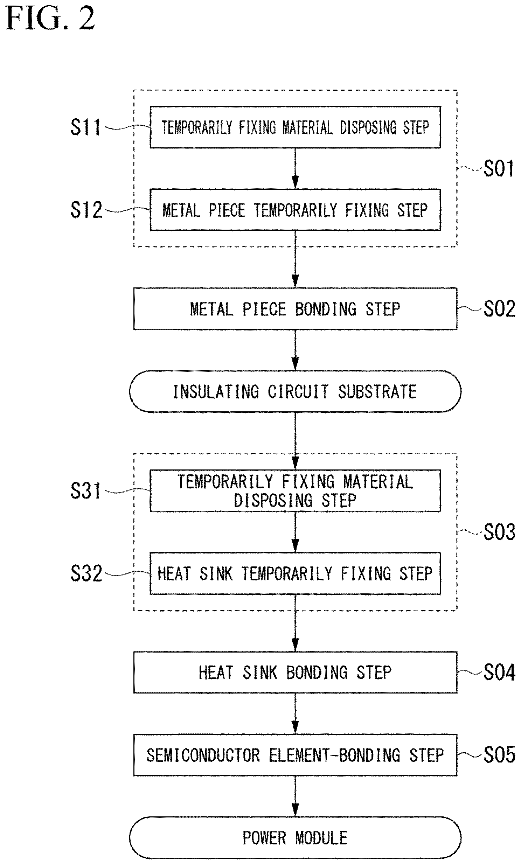

Next, the method for manufacturing the bonded body (a method for manufacturing an insulating circuit substrate and a method for manufacturing an insulating circuit substrate attached with a heat sink) according to the present embodiment will be described with reference to FIGS. 2 to 4.

### (Metal Piece Laminating Step S01)

First, as shown in FIG. 3, the metal piece 22 which is the circuit layer 12 is laminated on one surface of the ceramic substrate 11 through a brazing material foil 26, and the metal piece 23 which is the metal layer 13 is laminated on the other surface of the ceramic substrate 11 through a brazing material foil 27. In a case of bonding a ceramic substrate formed of AlN or Si₃N₄ to copper or a copper alloy, a brazing material containing a Ag and an active metal such as Ti is used. In a case of bonding a ceramic substrate formed of AlN or Si₃N₄ to aluminum or an aluminum alloy, a brazing material in which aluminum and silicon, or aluminum and copper are mixed is used.

In the present embodiment, since the ceramic substrate 11 formed of AlN and the metal pieces 22 and 23 formed of oxygen-free copper are bonded, an Ag-Cu-Ti-based brazing material is used as the brazing material foils 26 and 27. In addition, the thickness thereof is set to be in a range of 5 µm or more and 50 µm or less.

In a case of laminating the metal piece 22, the brazing material foil 26, the ceramic substrate 11, the brazing material foil 27, and the metal piece 23, first, as shown in FIG. 3, a temporarily fixing material 40 of the present embodiment is disposed between the metal piece 22, the brazing material foil 26, the ceramic substrate 11, the brazing material foil 27, and the metal piece 23 (temporarily fixing material disposing step S11). The disposition of the temporarily fixing material 40 is performed by, for example, application. An application amount of the temporarily fixing material 40 per unit area of the bonding surface is preferably 0.5 mg/cm² or more and 10 mg/cm² or less, and more preferably 1 mg/cm² or more and 5 mg/cm² or less.

Next, the metal piece 22, the brazing material foil 26, the ceramic substrate 11, the brazing material foil 27, and the metal piece 23 are temporarily fixed in a state of being positioned respectively by using the temporarily fixing material 40 (metal piece temporarily fixing step S12).

Here, the temporarily fixing material 40 according to the present embodiment includes an acrylic resin, a plasticizer composed of adipate, and a solvent, the amount of the acrylic resin is set to 5 mass% or more, and a ratio A/B of a weight A of the plasticizer to a weight B of the acrylic resin is set to be in a range of 0.07 ≤ A/B ≤ 1.50.

The amount of the acrylic resin is preferably 7 mass% or more and more preferably 10 mass% or more. On the other hand, the amount of the acrylic resin is preferably 60 mass% or less and more preferably 40 mass% or less.

In addition, the ratio A/B between the weight A of the plasticizer to the weight B of the acrylic resin is preferably 0.40 or more. On the other hand, the ratio A/B between the weight A of the plasticizer to the weight B of the acrylic resin is preferably 0.90 or less.

As the plasticizer consisting of adipate, for example, diisononyl adipate, diisodecyl adipate, bis(2-ethylhexyl) adipate, bis(2-butoxyethyl) adipate, and the like can be used. As the solvent, α-terpineol, texanol (3-hydroxy-2,2,4-trimethylpentyl isobutyrate), butyl carbitol acetate, or the like can be used.

In addition, in the temporarily fixing material 40 of the present embodiment, the amount of the solvent is preferably set to be in a range of 6.5 mass% or more and 86.0 mass% or less. Further, as the plasticizer consisting of adipate, in a case where a vapor pressure at 25°C is 5 × 10⁻³ Pa or less and a temperature is raised by TG-DTA, an exothermic peak due to decomposition is observed instead of an endothermic peak due to volatilization, and an organic material which is a liquid at room temperature (25°C) is more preferable.

In addition, as a method for applying the temporarily fixing material 40, various methods such as an application method using a dispenser, a screen-printing method, and an application method using a spray can be applied.

A viscosity range of the temporarily fixing material 40 at the time of application can be set to a viscosity range suitable for each application method. For example, in a case where a dispenser is used, the viscosity is preferably set to be in a range of 0.01 Pa·s or more and 10 Pa·s or less. In addition, in a case where screen printing is used, the viscosity is preferably set to be in a range of 10 Pa·s or more and 200 Pa·s or less. Further, in a case where a spray is used, the viscosity is preferably set to be in a range of 0.001 Pa·s or more and 10 Pa·s or less.

In the present embodiment, as shown in FIG. 3, the temporarily fixing material 40 is applied to the metal pieces 22 and 23 and the ceramic substrate 11, but the temporarily fixing material 40 can also be applied to both surfaces of the brazing material foils 26 and 27, without applying the temporarily fixing material 40 to the metal pieces 22 and 23 and the ceramic substrate 11.

A temporarily fixing material drying step of drying the disposed temporarily fixing material may be performed. In a case of drying the temporarily fixing material, it is preferable to dry the temporarily fixing material at a temperature equal to or higher than a volatilization temperature of the solvent and lower than a volatilization temperature of the plasticizer, or at a temperature equal to or higher than the volatilization temperature of the solvent and lower than a decomposition temperature of the plasticizer. A drying time is preferably set to be in a range of 5 seconds or more and 30 minutes or less.

Here, in the metal piece temporarily fixing step S12, it is preferable that the metal piece 22, the brazing material foil 26, the ceramic substrate 11, the brazing material foil 27, and the metal piece 23 laminated through the temporarily fixing material 40 are pressed in a laminating direction under conditions with a pressure in a range of 0.01 MPa or more and 1.0 MPa or less and a pressing time in a range of 1 second or more and 600 seconds or less.

The pressure in the metal piece temporarily fixing step S12 is more preferably set to 0.03 MPa or more and even more preferably set to 0.05 MPa or more. The pressure in the metal piece temporarily fixing step S12 is more preferably set to 0.7 MPa or less and even more preferably set to 0.5 MPa or less.

In addition, the pressing time in the metal piece temporarily fixing step S12 is more preferably set to 5 seconds or more, and even more preferably set to 10 seconds or longer. In addition, the pressing time in the metal piece temporarily fixing step S12 is more preferably set to 300 seconds or less, and even more preferably set to 120 seconds or less.

The temporarily fixing may be performed by a dead weight of the metal pieces 22 and 23 or the brazing material foils 26 and 27 without pressing.

### (Metal Piece Bonding Step S02)

Next, the metal piece 22, the brazing material foil 26, the ceramic substrate 11, the brazing material foil 27, and the metal piece 23, which are laminated and temporarily fixed to each other, are put into a vacuum heating furnace in a state of being pressed in the laminating direction using a pressing device, and the metal piece 22 and the ceramic substrate 11 are bonded to each other to form the circuit layer 12, and the metal piece 23 and the ceramic substrate 11 are bonded to each other to form the metal layer 13. A heating temperature is suitably selected depending on a metal piece to be bonded. In a case where the metal piece is copper or a copper alloy, the heating temperature is set to a eutectic point of Ag and Cu or higher, and in a case where the metal piece is aluminum or an aluminum alloy, the heating temperature is set to a eutectic point of aluminum and a metal included in the metal paste for bonding or higher.

In the present embodiment, as the ceramic substrate 11 formed of AlN and the metal pieces 22 and 23 formed of oxygen-free copper are bonded using the Ag-Cu-Ti-based brazing material foils 26 and 27, bonding conditions of this metal piece bonding step S02 are set so that a vacuum condition is in a range of 10⁻⁶ Pa or more and 10⁻³ Pa or less, a heating temperature is in a range of 790°C or higher and 850°C or lower, a retention time at the heating temperature is in a range of 0.1 minute or more and 120 minutes or less, and a pressing load in the laminating direction is in a range of 0.01 MPa or more and 1.0 MPa or less.

The heating temperature in the metal piece bonding step S02 is preferably set to 800°C or higher. Meanwhile, the heating temperature is preferably set to 840°C or lower.

In addition, the retention time at the heating temperature in the metal piece bonding step S02 is preferably set to 5 minutes or more. Meanwhile, the retention time at the heating temperature is preferably set to 60 minutes or less.

In addition, the pressure in the metal piece bonding step S02 is preferably set to 0.1 MPa or more. Meanwhile, the pressing load is preferably set to 0.6 MPa or less.

The insulating circuit substrate 10 is manufactured according to the steps described above.

### (Heat Sink Laminating Step S03)

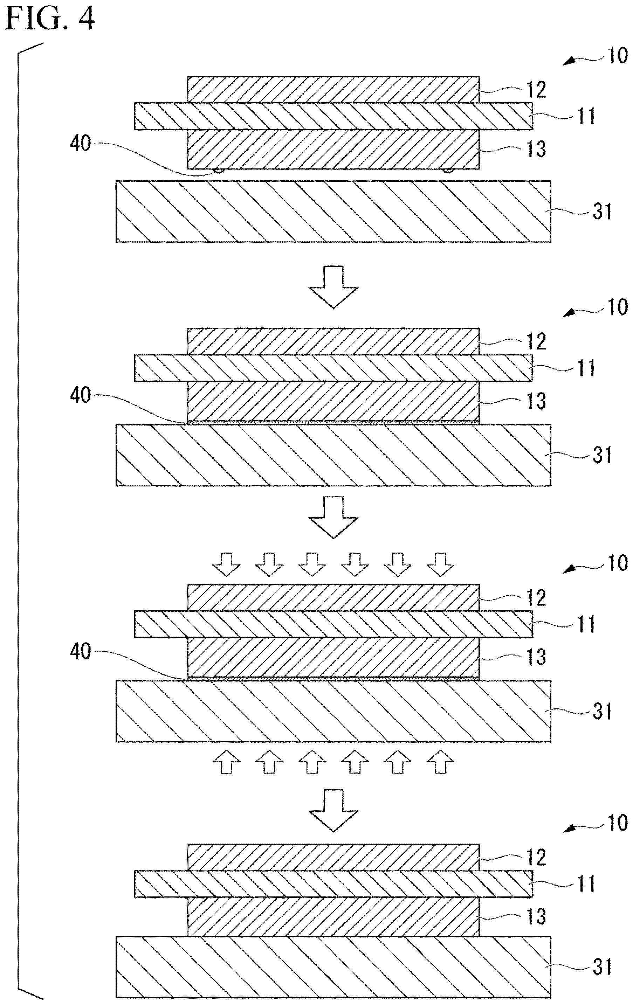

Next, as shown in FIG. 4, the insulating circuit substrate 10 (the metal layer 13) and the heat sink 31 are laminated.

In a case of laminating the insulating circuit substrate 10 (the metal layer 13) and the heat sink 31, first, as shown in FIG. 4, the temporarily fixing material 40 according to the present embodiment is disposed between the metal layer 13 and the heat sink 31. (temporarily fixing material disposing step S31).

Next, the metal layer 13 and the heat sink 31 are temporarily fixed in a state of being positioned using the temporarily fixing material 40 (heat sink temporarily fixing step S32).

As the temporarily fixing material 40 used in the present embodiment, a temporarily fixing material having the same configuration as the temporarily fixing material 40 described above can be applied. In addition, as a method for applying the temporarily fixing material 40, the method described above can be applied.

In the heat sink temporarily fixing step S32, it is preferable that the insulating circuit substrate 10 (the metal layer 13) and the heat sink 31, which are laminated through the temporarily fixing material 40, are pressed in the laminating direction under conditions with the pressure in a range of 0.01 MPa or more and 1.0 MPa or less and the pressing time in a range of 1 second or more and 600 seconds or less.

The pressure in the heat sink temporarily fixing step S32 is more preferably set to 0.03 MPa or more and even more preferably set to 0.05 MPa or more. The pressure in the heat sink temporarily fixing step S32 is more preferably set to 0.7 MPa or less and even more preferably set to 0.5 MPa or less.

In addition, the pressing time in the heat sink temporarily fixing step S32 is more preferably set to 5 seconds or more, and even more preferably set to 10 seconds or longer. In addition, the pressing time in the heat sink temporarily fixing step S32 is more preferably set to 300 seconds or less, and even more preferably set to 120 seconds or less.

### (Heat Sink Bonding Step S04)

Next, the laminated insulating circuit substrate 10 and heat sink 31 are put into a vacuum heating furnace in a state of being pressed in the laminating direction using a pressing device, and the metal layer 13 and the heat sink 31 are bonded by diffusion in solids.

Under bonding conditions in a heat sink bonding step S04, a vacuum condition is set to be in a range of 10⁻⁶ Pa or more and 10⁻³ Pa or less, a heating temperature is set to be in a range of 440°C or higher and 548°C or lower, and a retention time at the heating temperature is set to be in a range of 30 minutes or more and 150 minutes or less. A load in the laminating direction is preferably set to be in a range of 0.9 MPa or more and 1.2 MPa or less.

### (Semiconductor Element-Bonding Step S05)

Next, the semiconductor element 3 is bonded by soldering to one surface of the circuit layer 12 of the insulating circuit substrate 10.

The power module 1 shown in FIG. 1 is produced by the steps described above.

According to the temporarily fixing material 40 according to the present embodiment configured as described above includes an acrylic resin, and a plasticizer composed of adipate, the amount of the acrylic resin is set to 5 mass% or more, and a ratio A/B of a weight A of the plasticizer to a weight B of the acrylic resin is set to be in a range of 0.07 ≤ A/B ≤ 1.50. Therefore, the metal piece 22 and the brazing material foil 26, the brazing material foil 26 and the ceramic substrate 11, the ceramic substrate 11 and the brazing material foil 27, and the brazing material foil 27 and the metal piece 23 are respectively positioned and firmly temporarily fixed by an adhesive force of the temporarily fixing material 40 (for example, an adhesive force of 30 Pa or more and 50000 Pa or less, and in a case without the drying step of the temporarily fixing material, an adhesive force of 30 Pa or more and 900 Pa or less).

In the present embodiment, the temporarily fixing material 40 according to the present embodiment is disposed respectively between the metal piece 22 and the brazing material foil 26, the brazing material foil 26 and the ceramic substrate 11, the ceramic substrate 11 and the brazing material foil 27, and the brazing material foil 27 and the metal piece 23, and these are temporarily fixed in a state of being positioned by the temporarily fixing material 40. Therefore, it is possible to suppress occurrence of deviation in the metal piece bonding step S02 and the heat sink bonding step S04, and it is possible to bond the metal piece 22, the ceramic substrate 11, and the metal piece 23 with excellent positional accuracy.

In the present embodiment, in the metal piece temporarily fixing step S12, in a case where the pressing is configured to be performed in the laminating direction, the pressure is set to be in a range of 0.01 MPa or more and 1.0 MPa or less, and the pressing time is set to be in a range of 1 second or more and 600 seconds or less, it is possible to more reliably suppress the deviation of the metal piece 22, the brazing material foil 26, the ceramic substrate 11, the brazing material foil 27, and the metal piece 23, and it is possible to temporarily fix together the metal piece 22, the ceramic substrate 11, and the metal piece 23 with more excellent positional accuracy.

In addition, in the present embodiment, in the heat sink laminating step S03, in a case where the temporarily fixing material 40 according to the present embodiment is disposed on a bonding surface of the metal layer 13 and a bonding surface of the heat sink 31, and the metal layer 13 and the heat sink 31 are positioned and temporarily fixed, it is possible to suppress the occurrence of the deviation in the heat sink bonding step S04, and it is possible to bond the metal layer 13 and the heat sink 31 with excellent positional accuracy.

In addition, in the present embodiment, in the heat sink temporarily fixing step S32, when temporarily fixing the metal layer 13 and the heat sink 31, in a case where the pressing is configured to be performed in the laminating direction, the pressure is set to be in a range of 0.01 MPa or more and 1.0 MPa or less, and the pressing time is set to be in a range of 1 second or more and 600 seconds or less, it is possible to more firmly temporarily fix together the metal layer 13 and the heat sink 31, it is possible to further suppress the occurrence of the deviation in the heat sink bonding step S04, and it is possible to bond the metal layer 13 and the heat sink 31 with excellent positional accuracy.

### <Second Embodiment>

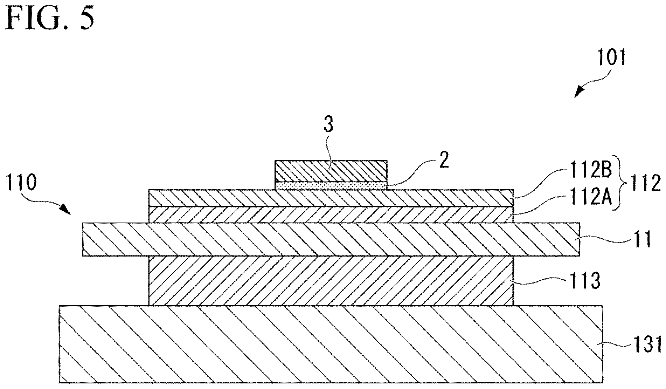

A second embodiment of the present invention will be described with reference to FIGS. 5 to 9. FIG. 5 shows an insulating circuit substrate 110 and a power module 101 manufactured by a method for manufacturing a bonded body using a temporarily fixing material of the present embodiment. The same members as in the first embodiment are designated by the same reference numerals and a detailed description thereof will be omitted.

The power module 101 includes the insulating circuit substrate 110 on which a circuit layer 112 and a metal layer 113 are disposed, the semiconductor element 3 bonded to one surface (upper surface in FIG. 5) of the circuit layer 112 through the bonding layer 2, and a heat sink 131 disposed on the other side (lower side in FIG. 5) of the metal layer 113.

In addition, the insulating circuit substrate 110 according to the present embodiment includes, as shown in FIG. 5, the ceramic substrate 11, the circuit layer 112 disposed on one surface (upper surface in FIG. 5) of the ceramic substrate 11, and the metal layer 113 disposed on the other surface (lower surface in FIG. 5) of the ceramic substrate 11.

As shown in FIG. 5, the circuit layer 112 includes an aluminum layer 112A disposed on one surface of the ceramic substrate 11 and a copper layer 112B laminated on one side (upper side in FIG. 5) of the aluminum layer 112A.

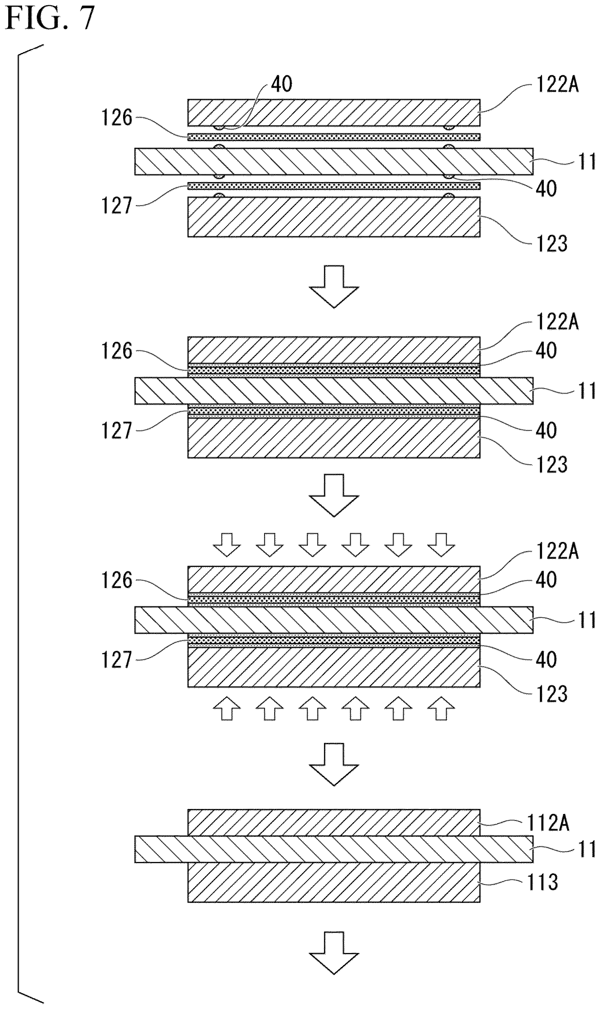

As shown in FIG. 7, the aluminum layer 112A is formed by bonding an aluminum piece 122A to one surface (upper surface in FIG. 7) of the ceramic substrate 11. In the present embodiment, as the aluminum piece 122A to be the aluminum layer 112A, an aluminum piece obtained by punching a rolled plate of aluminum having a purity of 99.99 mass% or more (so-called 4N aluminum) is used.

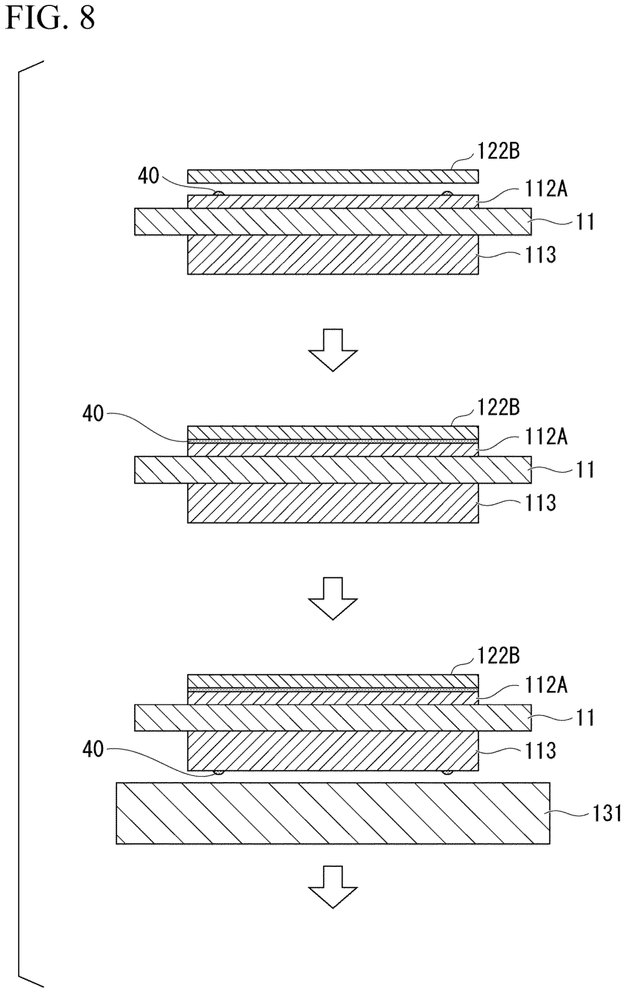

As shown in FIG. 8, the copper layer 112B is formed by bonding a copper piece 122B formed of copper or a copper alloy to one side (upper side in FIG. 8) of the aluminum layer 112A. In the present embodiment, as the copper piece 122B to be the copper layer 112B, a copper piece obtained by punching a rolled plate of oxygen-free copper is used.

In the present embodiment, in the circuit layer 112, the circuit pattern is formed by disposing the aluminum piece 122A and the copper piece 122B described above in a pattern, and one surface (upper surface in FIG. 5) thereof is a mounting surface on which the semiconductor element 3 is mounted.

Here, the thickness of the aluminum layer 112A configuring the circuit layer 112 is preferably set to be in a range of 0.1 mm or more and 1.0 mm or less, and the thickness of the copper layer 112B configuring the circuit layer 112 is preferably set to be in a range of 0.1 mm or more and 2.0 mm or less.

The aluminum layer 112A (the aluminum piece 122A) and the copper layer 112B (the copper piece 122B) are bonded by diffusion in solids. The circuit layer 112 (the aluminum layer 112A and the copper layer 112B) serves as the bonded body according to the present embodiment.

As shown in FIG. 7, the metal layer 113 is formed by bonding an aluminum piece 123 formed of aluminum or an aluminum alloy to the other surface (lower surface in FIG. 7) of the ceramic substrate 11. In the present embodiment, a rolled plate of aluminum having a purity of 99.99 mass% or more (e.g., 4N aluminum) is used as the aluminum piece 123 forming the metal layer 113.

The heat sink 131 is for dissipating heat on the insulating circuit substrate 110 side. The heat sink 131 is formed of copper or a copper alloy having excellent thermal conductivity, and in the present embodiment, is a heat dissipation plate configured with oxygen-free copper. The thickness of the heat sink 131 is set to be in a range of 3 mm or more and 10 mm or less.

In the present embodiment, the metal layer 113 of the insulating circuit substrate 110 and the heat sink 131 are bonded by bonding of diffusion in solids.

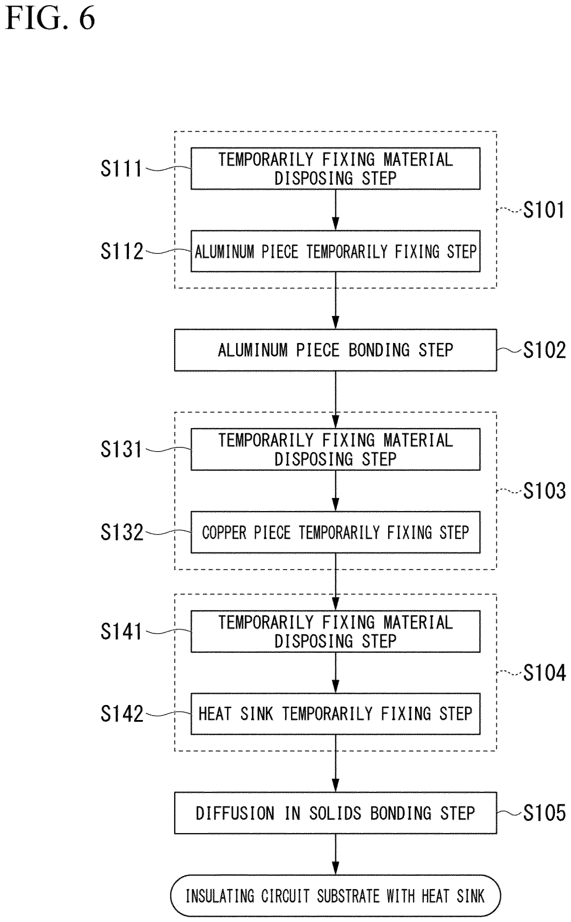

Next, the method for manufacturing the bonded body (a method for manufacturing an insulating circuit substrate and a method for manufacturing an insulating circuit substrate attached with a heat sink) according to the present embodiment will be described with reference to FIGS. 6 to 9.

### (Aluminum Piece Laminating Step S101)

First, as shown in FIG. 7, the aluminum piece 122A to be the aluminum layer 112A is laminated on one surface of the ceramic substrate 11 through the brazing material foil 126, and the aluminum piece 123 which is the metal layer 113 is laminated on the other surface of the ceramic substrate 11 through the brazing material foil 127.

Here, an Al-Si-based brazing material is used as the brazing material foils 126 and 127, and the thickness thereof is set to be in a range of 5 µm or more and 50 µm or less.

In a case of laminating the aluminum piece 122A, the brazing material foil 126, the ceramic substrate 11, the brazing material foil 127, and the aluminum piece 123, first, as shown in FIG. 7, the temporarily fixing material 40 of the present embodiment is disposed between the aluminum piece 122A and the brazing material foil 126, the brazing material foil 126 and the ceramic substrate 11, the ceramic substrate 11 and the brazing material foil 127, and the brazing material foil 127 and the aluminum piece 123 (temporarily fixing material disposing step S111).

Next, the aluminum piece 122A, the brazing material foil 126, the ceramic substrate 11, the brazing material foil 127, and the aluminum piece 123 are temporarily fixed in a state of being positioned respectively by using the temporarily fixing material 40 (aluminum piece temporarily fixing step S112).

As the temporarily fixing material 40 used in the present embodiment, a temporarily fixing material having the same configuration as the temporarily fixing material described in the first embodiment can be applied. In addition, as a method for applying the temporarily fixing material 40, the method described in the first embodiment can be applied.

Here, in the aluminum piece temporarily fixing step S112, it is preferable that the aluminum piece 122A, the brazing material foil 126, the ceramic substrate 11, the brazing material foil 127, and the aluminum piece 123 laminated through the temporarily fixing material 40 are pressed in a laminating direction under conditions with a pressure in a range of 0.01 MPa or more and 1.0 MPa or less and a pressing time in a range of 1 second or more and 600 seconds or less.

The pressure in the aluminum piece temporarily fixing step S112 is more preferably set to 0.03 MPa or more and even more preferably set to 0.05 MPa or more. The pressure in the aluminum piece temporarily fixing step S112 is more preferably set to 0.7 MPa or less and even more preferably set to 0.5 MPa or less.

In addition, the pressing time in the aluminum piece temporarily fixing step S112 is more preferably set to 5 seconds or more, and even more preferably set to 10 seconds or longer. In addition, the pressing time in the aluminum piece temporarily fixing step S112 is more preferably set to 300 seconds or less, and even more preferably set to 120 seconds or less.

### (Aluminum Piece Bonding Step S102)

Next, the aluminum piece 122A, the brazing material foil 126, the ceramic substrate 11, the brazing material foil 127, and the aluminum piece 123, which are laminated and temporarily fixed to each other, are put into a vacuum heating furnace in a state of being pressed in the laminating direction using a pressing device, and the aluminum piece 122A and the ceramic substrate 11 are bonded to each other to form the aluminum layer 112A, and the aluminum piece 123 and the ceramic substrate 11 are bonded to each other to form the metal layer 113.

Under bonding conditions in the aluminum piece bonding step S102, a vacuum condition is set to be in a range of 10⁻⁶ Pa or more and 10⁻³ Pa or less, a heating temperature is set to be in a range of 630°C or higher and 655°C or lower, a retention time at the heating temperature is set to be in a range of 1 minute or more and 180 minutes or less, and a pressing load in the laminating direction is set to be in a range of 0.01 MPa or more and 1.0 MPa or less.

The heating temperature in the aluminum piece bonding step S102 is preferably set to 635°C or higher. Meanwhile, the heating temperature is preferably set to 650°C or lower.

In addition, the retention time at the heating temperature in the aluminum piece bonding step S102 is preferably set to 5 minutes or more. Meanwhile, the retention time at the heating temperature is preferably set to 120 minutes or less.

In addition, the pressing load in the aluminum piece bonding step S102 is preferably set to 0.3 MPa or more. Meanwhile, the pressing load is preferably set to 0.6 MPa or less.

### (Copper Piece Laminating Step S103)

Next, as shown in FIG. 8, the copper piece 122B formed of copper or a copper alloy is laminated on a surface of the aluminum layer 112A.

In the copper piece laminating step S103, first, as shown in FIG. 8, the copper piece 122B to be the copper layer 112B is laminated on the surface of the aluminum layer 112A.

In a case of laminating the aluminum layer 112A and the copper piece 122B, first, as shown in FIG. 8, the temporarily fixing material 40 according to the present embodiment is disposed between the aluminum layer 112A and the copper piece 122B (temporarily fixing material disposing step S131).

Next, the aluminum layer 112A and the copper piece 122B are temporarily fixed in a state of being positioned using the temporarily fixing material 40 (copper piece temporarily fixing step S132).

As the temporarily fixing material 40 used in the present embodiment, a temporarily fixing material having the same configuration as the temporarily fixing material described in the first embodiment can be applied. In addition, as a method for applying the temporarily fixing material 40, the method described in the first embodiment can be applied.

In the copper piece temporarily fixing step S132, the aluminum layer 112A and the copper piece 122B which are laminated through the temporarily fixing material 40 are preferably pressed in the laminating direction under the conditions with the pressure in a range of 0.01 MPa or more and 1.0 MPa or less and the pressing time in a range of 1 second or more and 600 seconds or less.

The pressure in the copper piece temporarily fixing step S132 is more preferably set to 0.03 MPa or more and even more preferably set to 0.05 MPa or more. The pressure in the copper piece temporarily fixing step S132 is more preferably set to 0.7 MPa or less and even more preferably set to 0.5 MPa or less.

In addition, the pressing time in the copper piece temporarily fixing step S132 is more preferably set to 5 seconds or more, and even more preferably set to 10 seconds or longer. In addition, the pressing time in the copper piece temporarily fixing step S132 is more preferably set to 300 seconds or less, and even more preferably set to 120 seconds or less.

### (Heat Sink Laminating Step S104)

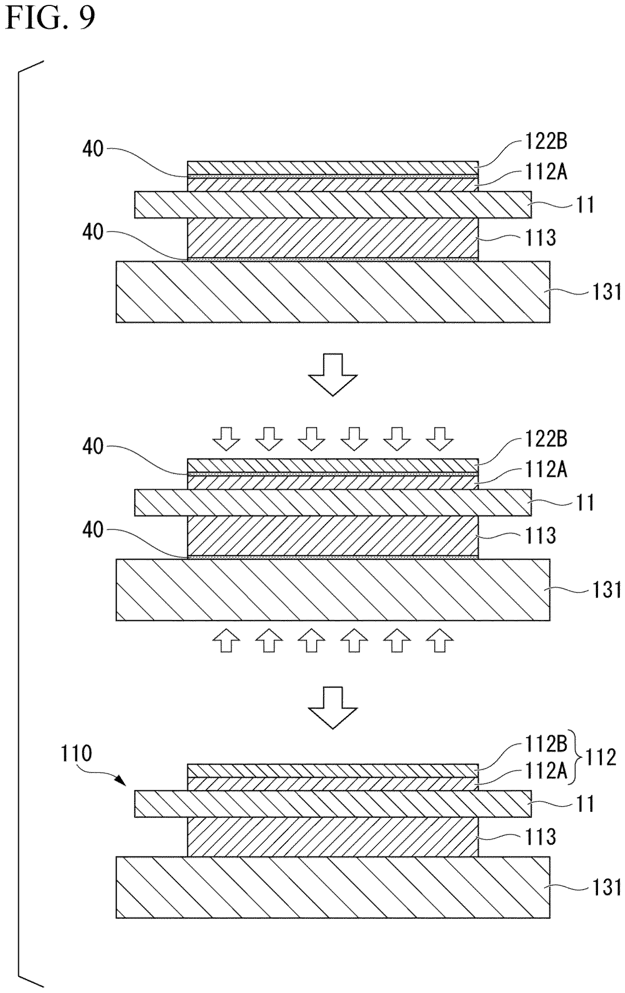

Next, as shown in FIGS. 8 and 9, the metal layer 113 and the heat sink 131 are laminated.

In a case of laminating the metal layer 113 and the heat sink 131, first, as shown in FIG. 8, the temporarily fixing material 40 according to the present embodiment is disposed between the metal layer 113 and the heat sink 131. (temporarily fixing material disposing step S141).

Next, the metal layer 113 and the heat sink 131 are temporarily fixed in a state of being positioned using the temporarily fixing material 40 (heat sink temporarily fixing step S142).

As the temporarily fixing material 40 used in the present embodiment, a temporarily fixing material having the same configuration as the temporarily fixing material described in the first embodiment can be applied. In addition, as a method for applying the temporarily fixing material 40, the method described in the first embodiment can be applied.

In the heat sink temporarily fixing step S142, it is preferable that the metal layer 113 formed of the aluminum member or the like and the heat sink 131 formed of the copper member or the like, which are laminated through the temporarily fixing material 40, are pressed in the laminating direction under conditions with the pressure in a range of 0.01 MPa or more and 1.0 MPa or less and the pressing time in a range of 1 second or more and 600 seconds or less.

The pressure in the heat sink temporarily fixing step S142 is more preferably set to 0.03 MPa or more and even more preferably set to 0.05 MPa or more. The pressure in the heat sink temporarily fixing step S142 is more preferably set to 0.7 MPa or less and even more preferably set to 0.5 MPa or less.

In addition, the pressing time in the heat sink temporarily fixing step S142 is more preferably set to 5 seconds or more, and even more preferably set to 10 seconds or longer. In addition, the pressing time in the heat sink temporarily fixing step S142 is more preferably set to 300 seconds or less, and even more preferably set to 120 seconds or less.

The copper piece laminating step S103 (the temporarily fixing material disposing step S131 and the copper piece temporarily fixing step S132) and the heat sink laminating step S104 (the temporarily fixing material disposing step S141 and the heat sink temporarily fixing step S142) described above may be performed at the same time.

### (Diffusion in Solids Bonding Step S105)

Next, as shown in FIG. 9, the temporarily fixed copper piece 122B and aluminum layer 112A, and the metal layer 113 and the heat sink 131 are put into a vacuum heating furnace in a state of being pressed in the laminating direction using the pressing device, the copper piece 122B and the aluminum layer 112A are bonded by diffusion in solids to form the circuit layer 112, and the metal layer 113 and the heat sink 131 are bonded by diffusion in solids.

Under bonding conditions in the diffusion in solids bonding step S105, a vacuum condition is set to be in a range of 10⁻⁶ Pa or more and 10⁻³ Pa or less, a heating temperature is set to be in a range of 400°C or higher and 548°C or lower, and a retention time at the heating temperature is set to be in a range of 5 minutes or more and 240 minutes or less. A load in the laminating direction is preferably set to be in a range of 0.9 MPa or more and 1.2 MPa or less.

The insulating circuit substrate 110 (the insulating circuit substrate attached with the heat sink) according to the present embodiment is manufactured by the steps described above.

According to the method for manufacturing the bonded body according to the present embodiment configured as described above, in the aluminum piece temporarily fixing step S112, the temporarily fixing material 40 according to the present embodiment is disposed respectively between the aluminum piece 122A and the brazing material foil 126, the brazing material foil 126 and the ceramic substrate 11, the ceramic substrate 11 and the brazing material foil 127, and the brazing material foil 127 and the aluminum piece 123, and these are temporarily fixed in a state of being positioned by the temporarily fixing material 40. Therefore, it is possible to suppress the occurrence of the deviation in the aluminum piece bonding step S102, and it is possible to bond the aluminum piece 122A, the ceramic substrate 11, and the aluminum piece 123 with excellent positional accuracy.

In addition, in the present embodiment, in the copper piece temporarily fixing step S132, the temporarily fixing material 40 according to the present embodiment is disposed between the aluminum layer 112A and the copper piece 122B, and the aluminum layer 112A and the copper piece 122B are temporarily fixed in a state of being positioned by the temporarily fixing material 40. Therefore, it is possible to suppress the occurrence of the deviation in the diffusion in solids bonding step S105, and it is possible to bond the aluminum layer 112A and the copper piece 122B by diffusion in solids with excellent positional accuracy.

In addition, in the present embodiment, in the heat sink temporarily fixing step S142, the metal layer 113 and the heat sink 131 are temporarily fixed in a state of being positioned using the temporarily fixing material 40 according to the present embodiment. Therefore, it is possible to suppress the occurrence of the deviation in the diffusion in solids bonding step S105, and it is possible to bond the metal layer 113 and the heat sink 131 by diffusion in solids with excellent positional accuracy.

In the present embodiment, in the aluminum piece temporarily fixing step S112, the pressing is configured to be performed in the laminating direction in the copper piece temporarily fixing step S132 and the heat sink temporarily fixing step S142. In a case where the pressure is set to be in a range of 0.01 MPa or more and 1.0 MPa or less and the pressing time is set to be in a range of 1 second or more and 600 seconds or less, it is possible to further reliably suppress the deviation of the aluminum piece 122A, the ceramic substrate 11, and the aluminum piece 123, the deviation of the aluminum layer 112A and the copper piece 122B, and the deviation of the metal layer 113 and the heat sink 131, and it is possible to temporarily fix with excellent positional accuracy.

The embodiments of the present invention have been described as above, but the present invention is not limited thereto, and can be appropriately changed without departing from the technical ideas of the present invention.

In the first embodiment, oxygen-free copper is used as the metal piece 22 (the circuit layer 12) and the metal piece 23 (the metal layer 13), however, is not limited thereto, and aluminum or an aluminum alloy may be used.

In the embodiment, the oxygen-free copper is used as the heat sink, aluminum or an aluminum alloy may be used.

For example, in the present embodiment, the power module configured by mounting a power semiconductor element on a circuit layer of an insulating circuit substrate has been described, but is not limited thereto. For example, an LED module may be configured by mounting an LED element on the insulating circuit substrate, or a thermoelectric module may also be configured by mounting a thermoelectric element on a circuit layer of an insulating circuit substrate.

In addition, in the present embodiment, the insulating layer configured with the ceramic substrate has been described, but is not limited thereto, and an insulating layer configured with a resin or the like may be used.

In addition, in the present embodiment, the bonding of the insulating circuit substrate (the metal layer) and the heat sink by the bonding of diffusion in solids has been described, but is not limited thereto, and other bonding methods such as brazing, TLP, and the like may be applied.

Further, in the present embodiment, the heat sink has been described as a heat dissipation plate, but is not limited thereto, and may include a passage in which a cooling medium flows.

### [Examples]

Hereinafter, results of confirmation experiments performed to confirm the effects of the present invention will be described.

### (Example 1)

An aluminum piece (40 mm × 40 mm × 0.4 mmt) formed of 4N aluminum having a purity of 99.99 mass% or more and a copper piece (37 mm × 37 mm × 0.8 mmt) formed of oxygen-free copper were prepared. A temporarily fixing material having a composition shown in Table 1 was prepared.

The temporarily fixing material was disposed between the aluminum piece and the copper piece, and the aluminum piece and the copper piece were laminated. The aluminum piece and the copper piece were temporarily fixed by pressing in the laminating direction with a pressure and a pressing time shown in Table 2.

After that, the temporarily fixed aluminum piece and copper piece were pressed and heated under conditions shown in Table 2, and accordingly, the aluminum piece and the copper piece were bonded by diffusion in solids.

Then, the items below were evaluated.

### (Fixing Strength in Horizontal Direction)

Shear strengths of the temporarily fixed aluminum piece and copper piece were measured using a bonding tester PTR-1101 manufactured by RHESCA Co., Ltd. A tool was placed on a side surface of the copper piece, and moved against the aluminum piece in a horizontal direction, that is, a parallel direction to a bonding surface with the aluminum piece, and a load applied when the copper piece was peeled off from the temporarily fixing material was measured and obtained as the fixing strength in the horizontal direction. The shear speed (a speed for moving the tool) was set to 0.05 mm/sec. Evaluation results are shown in Table 2.

### (Fixing Strength in Vertical Direction)

Copper pieces having various weights with an adjusted thickness were prepared. Each of these copper pieces was temporarily fixed to an aluminum piece. Each temporarily fixing material shown in Table 1 was used such that the copper pieces faced a lower side in the vertical direction, and the temporarily fixing was performed under conditions of the temporarily fixing step described in Table 2. In the order of a laminated body to which a lightweight copper piece was temporarily fixed and a laminated body to which a heavy copper piece was temporarily fixed, the laminated body was set so that the copper piece faces a lower side in the vertical direction, and a weight of the copper piece of the laminated body when the copper piece fell within approximately 10 seconds to a weight of the copper piece when the copper piece fell per unit area of the temporarily fixing material were calculated and obtained as the fixing strength in the vertical direction.

### (Evaluation of Bonding Properties)

A bonding rate of a bonded interface between the bonded aluminum piece and copper piece was evaluated using an ultrasonic flaw detector (FineSAT200 manufactured by Hitachi Power Solutions Co., Ltd.) and calculated from the following formula. Here, an initial bonding area was an area to be bonded before bonding. In a case where the bonding surface was divided into a plurality of areas, the sum of the bonding areas thereof was set as the initial bonding area. In an image obtained by binarizing an ultrasonic-detected image, the peeling was indicated by a white part in a bonding part, and therefore, an area of this white part was set as an exfoliation area (a non-bonding part area). (Bonding rate) = [{(initial bonding area) - (non-bonding part area)}/(initial bonding area)] × 100

**[Table 1]**

| | Temporarily fixing material | | | | | |
|---|---|---|---|---|---|---|
| | Plasticizer | | Acrylic resin | Weight ratio A/B of plasticizer A and acrylic resin B | Solvent | |
| | Material | Content (mass%) | Content (mass%) | | Material | Content (mass%) |
| Present Invention Example 1 | Diisononyl adipate | 43.5 | 50.0 | 0.87 | α-terpineol | 6.5 |
| Present Invention Example 2 | Diisononyl adipate | 4.0 | 10.0 | 0.40 | Texanol | 86.0 |
| Present Invention Example 3 | Diisononyl adipate | 14.0 | 20.0 | 0.70 | α-terpineol | 66.0 |
| Present Invention Example 4 | Bis(2-ethylhexyl) adipate | 33.0 | 60.0 | 0.55 | α-terpineol | 7.0 |
| Present Invention Example 5 | Bis(2-butoxyethyl) adipate | 2.0 | 10.0 | 0.20 | Butyl carbitol acetate | 88.0 |
| Present Invention Example 6 | Diisononyl adipate | 5.6 | 7.0 | 0.80 | α-terpineol | 87.4 |
| Present Invention Example 7 | Diisononyl adipate | 2.8 | 40.0 | 0.07 | α-terpineol | 57.2 |
| Comparative Example 1 | Diisononyl adipate | 2.5 | 50.0 | 0.05 | α-terpineol | 47.5 |
| Comparative Example 2 | Diisononyl adipate | 50.0 | 0.0 | - | α-terpineol | 50.0 |
| Comparative Example 3 | Diisononyl adipate | 1.8 | 3.0 | 0.60 | α-terpineol | 95.2 |

**[Table 2]**

| | Manufacturing step | | | | | | Evaluation | | |
|---|---|---|---|---|---|---|---|---|---|
| | Temporarily fixing step | | | diffusion in solids bonding step | | | Fixing strength in horizontal direction (Pa) | Fixing strength in vertical direction (KPa) | Bonding rate (%) |
| | Application amount (mg/cm²) | Pressure (MPa) | Pressing time (sec) | Pressure (MPa) | Heating temperature (°C) | Retention time (min) | | | |
| Present Invention Example 1 | 2.5 | 0.01 | 600 | 1 | 540 | 60 | 114 | 0.8 | 99.1 |
| Present Invention Example 2 | 2.5 | 1.00 | 300 | 1 | 540 | 60 | 536 | 0.8 | 99.5 |
| Present Invention Example 3 | 2.5 | 0.05 | 120 | 1 | 540 | 60 | 367 | 0.4 | 100.0 |
| Present Invention Example 4 | 2.5 | 0.03 | 1 | 1 | 540 | 60 | 862 | 4.0 | 98.6 |
| Present Invention Example 5 | 2.5 | 0.50 | 10 | 1 | 540 | 60 | 223 | 0.8 | 99.1 |
| Present Invention Example 6 | 2.5 | 0.70 | 5 | 1 | 540 | 60 | 128 | 0.4 | 98.9 |
| Present Invention Example 7 | 2.5 | 0.20 | 60 | 1 | 540 | 60 | 37 | 4.0 | 100.0 |
| Comparative Example 1 | 2.5 | 0.50 | 60 | 1 | 540 | 60 | 0 | 0.0 | 99.1 |
| Comparative Example 2 | 2.5 | 0.50 | 60 | 1 | 540 | 60 | 0 | 0.0 | 99.4 |
| Comparative Example 3 | 2.5 | 0.50 | 60 | 1 | 540 | 60 | 0 | 0.0 | 99.4 |

In Comparative Example 1, the ratio A/B of the weight A of the plasticizer to the weight B of the acrylic resin was set to 0.05, which was smaller than the range of the present invention, the fixing strength in the horizontal direction and the fixing strength in the vertical direction at the time of temporarily fixing were 0 Pa, and it was not possible to temporarily fix together the aluminum piece and the copper piece.

In Comparative Example 2, the acrylic resin was not included, the fixing strength in the horizontal direction and the fixing strength in the vertical direction at the time of temporarily fixing were 0 Pa, and it was not possible to temporarily fix together the aluminum piece and the copper piece.

In Comparative Example 3, the amount of the acrylic resin was set to 3.0 mass%, the fixing strength in the horizontal direction and the fixing strength in the vertical direction at the time of temporarily fixing were 0 Pa, and it was not possible to temporarily fix together the aluminum piece and the copper piece.

On the other hand, in Present Invention Examples 1 to 7, the amount of the acrylic resin was set to 5 mass% or more, the ratio A/B between the weight A of the plasticizer to the weight B of the acrylic resin was set to be in a range of 0.07 ≤ A/B ≤ 1.50, the fixing strength in the horizontal direction at the time of temporarily fixing was set to 37 Pa or more, the fixing strength in the vertical direction was set to 0.4 kPa or more, and it was possible to reliably temporarily fix together the aluminum piece and the copper piece.

### (Example 2)

A ceramic substrate (40 mm × 40 mm × 0.635 mmt) formed of aluminum nitride, and an aluminum piece (37 mm × 37 mm × 0.4 mmt) formed of 4N aluminum having a purity of 99.99 mass% or more and to which the Al-Si brazing material was fixed with ultrasonic waves were prepared. A temporarily fixing material having a composition shown in Table 3 was prepared.

**[Table 3]**

| | Temporarily fixing material | | | | | |
|---|---|---|---|---|---|---|
| | Plasticizer | | Acrylic resin | Weight ratio A/B of plasticizer A and acrylic resin B | Solvent | |
| | Material | Content (mass%) | Content (mass%) | | Material | Content (mass%) |
| Present Invention Example 11 | Diisononyl adipate | 16.0 | 12.0 | 1.33 | α-terpineol | 72.0 |
| Present Invention Example 12 | Diisononyl adipate | 2.0 | 5.0 | 0.40 | α-terpineol | 93.0 |
| Comparative Example 11 | Diisononyl adipate | 40.0 | 25.0 | 1.60 | α-terpineol | 35.0 |
| Comparative Example 12 | Diisononyl adipate | 2.5 | 50.0 | 0.05 | α-terpineol | 47.5 |

The temporarily fixing material was applied onto the ceramic substrate, and the applied temporarily fixing material was dried in a hot air drying furnace under the conditions shown in Table 4. The aluminum piece with the brazing material foil was laminated on the ceramic substrate on which the dried temporarily fixing material was disposed such that the brazing material faced the ceramic substrate, and the ceramic substrate and the aluminum piece were temporarily fixed by pressing in the laminating direction with the pressure and the pressing time shown in Table 4.

After that, the temporarily fixed ceramic substrate and aluminum piece with the brazing material were pressed and heated under conditions shown in Table 4, and the ceramic substrate and the aluminum piece were bonded.

In the same manner as in Example 1, the fixing strength in the horizontal direction, the fixing strength in the vertical direction, and the evaluation of bonding properties were evaluated.

### (Fixing Strength in Horizontal Direction)

Shear strengths of the temporarily fixed ceramic substrate and aluminum piece were measured using a bonding tester PTR-1101 manufactured by RHESCA Co., Ltd. A tool was placed on a side surface of the aluminum piece, and moved against the ceramic substrate in a horizontal direction, and a load applied when the aluminum piece was peeled off from the temporarily fixing material was measured and obtained as the fixing strength in the horizontal direction. The shear speed (a speed for moving the tool) was set to 0.05 mm/sec. Evaluation results are shown in Table 4.

### (Fixing Strength in Vertical Direction)

Aluminum pieces having various weights with an adjusted thickness were prepared. Each of these aluminum pieces was temporarily fixed to a ceramic substrate. Each temporarily fixing material shown in Table 3 was used such that the aluminum pieces faced a lower side in the vertical direction, and the temporarily fixing was performed under conditions of the temporarily fixing step described in Table 4. A laminated body in which the aluminum piece was temporarily fixed to the ceramic substrate was manufactured, the aluminum piece was set to face a lower side in the vertical direction, and a weight of the aluminum piece when the aluminum piece fell within approximately 10 seconds to a weight of the aluminum piece when the aluminum piece fell per unit area of the temporarily fixing material were calculated and obtained as the fixing strength in the vertical direction.

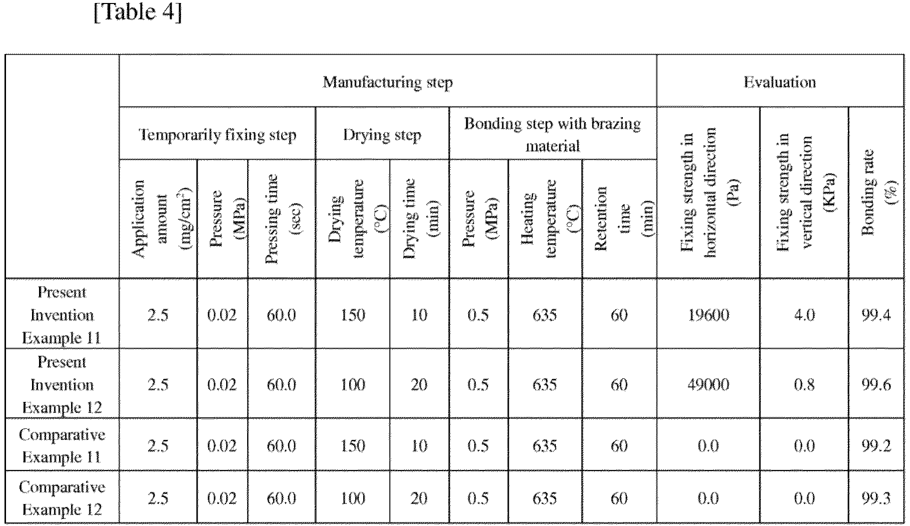

### (Evaluation of Bonding Properties)

A bonding rate of a bonded interface after bonding was evaluated using an ultrasonic flaw detector (FineSAT200 manufactured by Hitachi Power Solutions Co., Ltd.) and calculated from the following formula. Here, an initial bonding area was an area to be bonded before bonding. In an image obtained by binarizing an ultrasonic-detected image, the peeling was indicated by a white part in a bonding part, and therefore, an area of this white part was set as an exfoliation area (a non-bonding part area). (Bonding rate) = [{(initial bonding area) - (non-bonding part area)}/(initial bonding area)] × 100

In Comparative Example 11, the ratio A/B of the weight A of the plasticizer to the weight B of the acrylic resin was set to 1.60, which was greater than the range of the present invention, the fixing strength in the horizontal direction and the fixing strength in the vertical direction at the time of temporarily fixing were 0 Pa, and it was not possible to temporarily fix together the aluminum piece and the ceramic substrate.

In Comparative Example 12, the ratio A/B of the weight A of the plasticizer to the weight B of the acrylic resin was set to 0.05, which was smaller than the range of the present invention, the fixing strength in the horizontal direction and the fixing strength in the vertical direction at the time of temporarily fixing were 0 Pa, and it was not possible to temporarily fix together the aluminum piece and the ceramic substrate.

On the other hand, in Present Invention Examples 11 and 12, the amount of the acrylic resin was set to 5 mass% or more, the ratio A/B between the weight A of the plasticizer to the weight B of the acrylic resin was set to be in a range of 0.07 ≤ A/B ≤ 1.50, the fixing strength in the horizontal direction at the time of temporarily fixing, and the fixing strength in the vertical direction were sufficiently high, and it was possible to reliably temporarily fix together the aluminum piece and the ceramic substrate.

From the results of Present Invention Examples, according to the present invention, it was confirmed that it was possible to provide a temporarily fixing material capable of reliably temporarily fixing members to each other, and a method for manufacturing a bonded body capable of bonding members with excellent positional accuracy by positioning the members using the temporarily fixing material.

### [Industrial Applicability]

According to the present invention, it is possible to provide a temporarily fixing material capable of reliably temporarily fixing members to each other, and a method for manufacturing a bonded body capable of bonding members with excellent positional accuracy by positioning the members using the temporarily fixing material.

### REFERENCE SIGNS LIST

1, 101: Power module
3: Semiconductor element
10, 110: Insulating circuit substrate
11 Ceramic substrate
12, 112 Circuit layer
13, 113 Metal layer
22: Metal piece
23: Metal piece
26, 126: Brazing material foil
27, 127 Brazing material foil
31, 131: Heat sink
40: Temporarily fixing material
112A: Aluminum layer
112B: Copper layer
122A: Aluminum piece
122B Copper piece
123 Aluminum piece

## Claims

1. A temporarily fixing material comprising:
an acrylic resin;
a plasticizer consisting of adipate; and
a solvent,
wherein an amount of the acrylic resin is 5 mass% or more, and
a ratio A/B of a weight A of the plasticizer to a weight B of the acrylic resin is in a range of 0.07 ≤ A/B ≤ 1.50.

2. A method for manufacturing a bonded body in which a first member and a second member are bonded, the method comprising:
a laminating step of laminating the first member and the second member; and
a bonding step of bonding the laminated first member and second member,
wherein the laminating step includes a temporarily fixing material disposing step of disposing the temporarily fixing material according to Claim 1 on one or both of bonding surfaces of the first member and the second member, and a temporarily fixing step of laminating the first member and the second member through the temporarily fixing material and temporarily fixing the laminated first member and second member.

3. The method for manufacturing the bonded body according to Claim 2, comprising:
a temporarily fixing material drying step of drying the temporarily fixing material disposed in the temporarily fixing material disposing step, before the temporarily fixing step.

4. The method for manufacturing the bonded body according to Claim 2 or 3,
wherein the first member is an aluminum member formed of aluminum or an aluminum alloy, and the second member is a copper member formed of copper or a copper alloy.

5. The method for manufacturing the bonded body according to Claim 4,
wherein the first member is a heat sink.

6. The method for manufacturing a bonded body according to Claim 4,
wherein the second member is a heat sink.

7. The method for manufacturing a bonded body according to Claim 2 or 3,
wherein the first member is a metal part, and the second member is a brazing material.

8. The method for manufacturing a bonded body according to Claim 2 or 3,
wherein the first member is an aluminum member formed of aluminum or an aluminum alloy, and the second member is an aluminum member formed of aluminum or an aluminum alloy.

9. The method for manufacturing a bonded body according to Claim 2 or 3,
wherein the first member is a copper member formed of copper or a copper alloy, and the second member is a copper member formed of copper or a copper alloy.

10. The method for manufacturing a bonded body according to Claim 2 or 3,
wherein the first member is a ceramic member, and the second member is a brazing material.
